# EUROPÄISCHE PATENTSCHRIFT

(11) **EP 0 645 953 B1**
(45) Veröffentlichungstag und Bekanntmachung des Hinweises auf die Patenterteilung: **06.08.1997**
(21) Anmeldenummer: 94114453.7
(22) Anmeldetag: 14.09.1994
(51) Int. Cl.: H05K 3/46, H01L 23/02

(54) **Verfahren zur Herstellung einer zwei- oder mehrlagigen Verdrahtung und danach hergestellte zwei- oder mehrlagige Verdrahtung**
Method of producing a two or multilayer wiring structure and two or multilayer structure made thereof
Procédé de fabrication d'un câblage à deux ou plusieurs couches, et câblage à deux ou plusieurs couches

(30) Priorität: 29.09.1993 DE 4333338
(43) Veröffentlichungstag der Anmeldung: 29.03.1995
(73) Patentinhaber: Siemens NV, 8020 Oostkamp (BE); MELEXIS, 8900 Ieper (BE); INTERUNIVERSITAIR MICROELEKTRONICA CENTRUM VZW, 3001 Leuven (BE)
(72) Erfinder: van Puymbroeck, Josef, B-8020 Oostkamp (BE); Bulcke, Fred, B-8900 Ieper (BE); Beyne, Eric, Dr., B-3001 Leuven (BE)
(74) Vertreter: Fuchs, Franz-Josef, Dr.-Ing.

(56) Entgegenhaltungen:
- EP-A- 0 526 243
- US-A- 4 769 309
- US-A- 4 964 019
- PATENT ABSTRACTS OF JAPAN, unexamined applications, E Field, Band 16, Nr. 542, 12. November 1992 THE PATENT OFFICE JAPANESE GOVERNMENT Seite 92 E 1290; & JP-A-04 206 989
- PATENT ABSTRACTS OF JAPAN, unexamined applications, E Field, Band 11, Nr. 148, 14. Mai 1987 THE PATENT OFFICE JAPANESE GOVERNMENT Seite 44 E 506; & JP-A-61 285 739
- PATENT ABSTRACTS OF JAPAN, unexamined applications, E Field, Band 13, Nr. 496, 9. November 1989 THE PATENT OFFICE JAPANESE GOVERNMENT Seite 85 E 843; & JP-A-01 199 460

## Beschreibung

Aus dem Aufsatz "Integration mit SIL-Technik" in der DE-Z Siemens-Zeitschrift Special · FuE · Herbst 1992, Seiten 4 bis 9, ist die sogenannte SIL-Technik bekannt, welche anstelle konventioneller gedruckter Schaltungen Spritzgießteile mit integrierten Leiterzügen verwendet. Anstelle der Bezeichnung SIL ist international die Bezeichnung MID (Molded Interconnect Device) am gebräuchlichsten. Hochwertige Thermoplaste, die sich zum Spritzgießen von dreidimensionalen, das heißt, räumlich geformten Teilen eignen, sind die Basis dieser Technikl. Derartige Thermoplaste zeichnen sich gegenüber herkömmlichen Substratmaterialien für gedruckte Schaltungen durch bessere mechanische, thermische, chemische, elektrische und umwelttechnische Eigenschaften aus. Die Strukturierung einer auf die Spritzgießteile aufgebrachten Metallschicht erfolgt unter Verzicht auf die sonst übliche Maskentechnik durch ein spezielles Laserstrukturierungsverfahren. In die dreidimensionalen Spritzgießteile mit strukturierter Metallisierung sind dabei mehrere mechanische und elektrische Funktionen integrierbar. Die Gehäuseträgerfunktion übernimmt gleichzeitig Führungen und Schnappverbindungen, während die Metallisierungsschicht neben der Verdrahtungs- und Verbindungsfunktion auch als elektromagnetische Abschirmung dient und für eine gute Wärmeabfuhr sorgt. Der direkte Anschluß und die Aufnahme von SMD-Bauelementen und ungehäusten Halbleiterbauelementen bietet ein weiteres Integrationspotential.

Weitere Einzelheiten zur Herstellung von dreidimensionalen Spritzgießteilen mit integrierten Leiterzügen gehen beispielsweise aus der DE-A-37 32 249 oder der EP-A-0 361 192 hervor.

Beispielsweise aus der EP-A-0 478 313 ist es auch bekannt, auf beiden Seiten eines Substrats aus glasfaserverstärktem Epoxidharz zwei oder mehrere Leiterebenen auszubilden. Zur Herstellung derartiger Mehrlagenverdrahtungen erfolgt die Bildung der Leiterebenen durch Strukturierung von Metallschichten, auf welche dann photoempfindliche Dielektrikumsschichten aufgebracht werden, die anschließend zur Bildung von Kontaktlöchern, photolithographisch strukturiert werden. Auf die strukturierten Dielektrikumsschichten wird dann jeweils wieder eine Metallschicht aufgebracht und zur Bildung der nächsten Leiterebene strukturiert, wobei die nächste Leiterebene im Bereich der vorstehend erwähnten Kontaktlöcher mit der darunterliegenden Leiterebene elektrisch leitend verbunden ist. Die fertige Mehrlagenverdrahtung kann dann mit SMD-Bauelementen oder mit herkömmlichen bedrahteten Bauelementen bestückt werden.

Der in den Ansprüchen 1 und 22 angegebenen Erfindung liegt das Problem zugrunde, eine für die Aufnahme von ungehäusten elektronischen Bauelementen, insbesondere Chips, geeignete, mindestens zweilagige Verdrahtung zu schaffen, die einen kompakten und dünnen Aufbau mit einer hohen Verdrahtungsdichte ermöglicht.

Die mit der Erfindung erzielten Vorteile bestehen insbesondere darin, daß durch die Kombination der zur Herstellung von Spritzgießteilen mit integrierten Leiterzügen und zur Herstellung von Mehrlagenverdrahtungen entwickelten Technologien auch die Vorteile dieser beiden Technologien gemeinsam realisiert werden können. So kann einerseits bei einem kompakten und dünnen Aufbau die Verdrahtungsdichte erheblich gesteigert werden, während andererseits das durch Spritzgießen hergestellte Substrat mehrere Funktionen als Verpackung, Träger und elektromagnetische Abschirmung erfüllen kann und auch eine gute Wärmeableitung ermöglicht. Bei der Bestückung der Verdrahtung mit Bauelementen können sämtliche bekannten Montagetechnologien angewandt werden. Als besonderer Vorteil ist aber auch die vesunkene Montage von elektronischen Bauelementen in Mulden des spritzggossenen Substrats hervorzuheben, da hierdurch eine extrem geringe Dicke der bestückten Schaltung realisiert werden kann und neben einem optimalen Schutz auch eine einfache und hermetisch dichte Verkapselung ungehäuster Bauelemente ermöglicht wird.

Vorteilhafte Ausgestaltungen des erfindungsgemäßen Verfahrens sind in den Ansprüchen 2 bis 21 angegeben.

Die Ausgestaltung nach Anspruch 2 ermöglicht eine wirtschaftliche Herstellung von Durchkontaktierungslöchern beim Spritzgießen des Substrats.

Gemäß Anspruch 3 können beim Spritzgießen des Substrats auch im Bereich der Mulden Löcher hergestellt werden, die dann eine Abfuhr der von den in den Mulden angeordneten Bauelementen erzeugten Wärme begünstigen.

Die Weiterbildung nach Anspruch 4 bietet die Möglichkeit, die gesamten elektrisch leitenden Verbindungen zwischen den Anschlüssen des Bauelements und den zugeordneten Anschlußflächen auf dem Substrat in die Verkapselung einzubeziehen und damit optimal zu schützen.

Wird die erste Metallschicht gemäß Anspruch 5 ganzflächig auf das Substrat aufgebracht, so kann eine Abschirmung oder Maskierung des Substrats entfallen, während die erste Metallschicht neben der Bildung von Leiterebenen auch Aufgaben als elektromagnetische Abschirmung, zur Wärmeabfuhr und dergleichen übernehmen kann.

Die Ausgestaltung nach Anspruch 6 hat den Vorteil, daß zur Herstellung der ersten Metallschicht auf Technologien zurückgegriffen werden kann, die sich bei der Herstellung gedruckter Schaltungen seit langer Zeit bewährt haben.

Wird die erste Metallschicht gemäß Anspruch 7 zur Herstellung der ersten Leiterebene durch Laserablation strukturiert, so kann diese Strukturierung unter Verzicht auf die Maskentechnik und auf eine naßchemische Behandlung besonders rasch und wirtschaftlich durchgeführt werden.

Die Ausgestaltung nach Anspruch 8 ermöglicht eine einfache und wirtschaftliche photolithographische Strukturierung der Dielektrikumsschicht.

Gemäß Anspruch 9 wird auch die zweite Metallschicht vorzugsweise ganzflächig auf die Dielektrikumsschicht und die erste Metallschicht aufgebracht, so daß auch hier auf entsprechende Abdeckungen oder Maskierungen verzichtet werden kann.

Die Weiterbildung nach Anspruch 10 bietet eine einfache und wirtschaftliche Möglichkeit zur Strukturierung der zweiten Metallschicht. Die hierzu erforderliche Ätzresistschicht kann dabei gemäß Anspruch 11 aus einem photoempfindlichen organischen Material hergestellt und photolithographisch strukturiert werden. Gemäß Anspruch 12 kann eine Ätzresistschicht aber auch durch die Abscheidung von Zinn hergestellt und mittels Laserablation strukturiert werden.

Die Ausgestaltung nach Anspruch 13 ermöglicht eine einfache und sichere Befestigung des Bauelements in der Mulde durch Kleben. Wird dabei gemäß Anspruch 14 ein elektrisch leitender Kleber verwendet, so kann bei der Befestigung des Bauelements auch gleichzeitig eine elektrisch leitende Verbindung mit einer Leiterebene realisiert werden.

Die Anordnung und Kontaktierung eines in einer Mulde des Substrats untergebrachten Bauelements kann prinzipiell auch in Flip-Chip-Technik vorgenommen werden. Gemäß Anspruch 15 ist die erfindungsgemäße Verdrahtung aber insbesondere auf die Anwendung der Bondtechnik abgestimmt, da die Herstellung der Bondverbindungen direkt von oben her vorgenommen werden kann und die feinen Bonddrähte durch die nachfolgend hergestellte Verkapselung optimal geschützt werden können.

Die Ausgestaltung nach Anspruch 16 ermöglicht eine besonders einfache und sichere Verkapselung des in der Mulde untergebrachten Bauelements.

Die Weiterbildung nach Anspruch 17 ermöglicht die Ausnutzung der der Mulde gegenüberliegenden Seite des Substrats für die Herstellung mindestens einer weiteren Leiterebene. Gemäß Anspruch 18 kann diese weitere Leiterebene dabei mit einem Minimum an Aufwand durch Strukturierung der ersten Metallschicht und der zweiten Metallschicht gebildet werden.

Die Ausgestaltung nach Anspruch 19 ermöglicht elektrisch leitende Verbindungen zwischen der weiteren Leiterebene und der ersten Leiterebene über Durchkontaktierungslöcher, die bereits beim Spritzgießen des Substrats hergestellt werden können.

Die Weiterbildung nach Anspruch 20 ermöglicht einen einfachen und wirksamen Schutz, der nicht für die Bestückung mit Bauelementen erforderlichen Bereiche der weiteren Leiterebene.

Gemäß Anspruch 21 können für die Bestückung der weiteren Leiterebene mit Bauelementen die Vorteile der Oberflächenmontage ausgenutzt werden.

Vorteilhafte Ausgestaltungen der erfindungsgemäßen zwei- oder mehrlagigen Verdrahtung gehen aus den Ansprüchen 23 bis 25 hervor, wobei die Vorteile dieser Ausgestaltungen bereits im Zusammenhang mit entsprechenden Ausgestaltungen des erfindungsgemäßen Verfahrens erörtert wurden.

Ein Ausführungsbeispiel der Erfindung ist in der Zeichnung dargestellt und wird im folgenden näher beschrieben.

Es zeigen
Figur 1 bis Figur 8 in stark vereinfachter schematischer Darstellung verschiedene Stadien bei der Herstellung von drei Leiterebenen auf einem spritzgegossenen Substrat und
Figur 9 einen Querschnitt durch die fertige Verdrahtung nach Befestigung, Kontaktierung und Verkapselung eines in einer Mulde des Substrats angeordneten Chips.

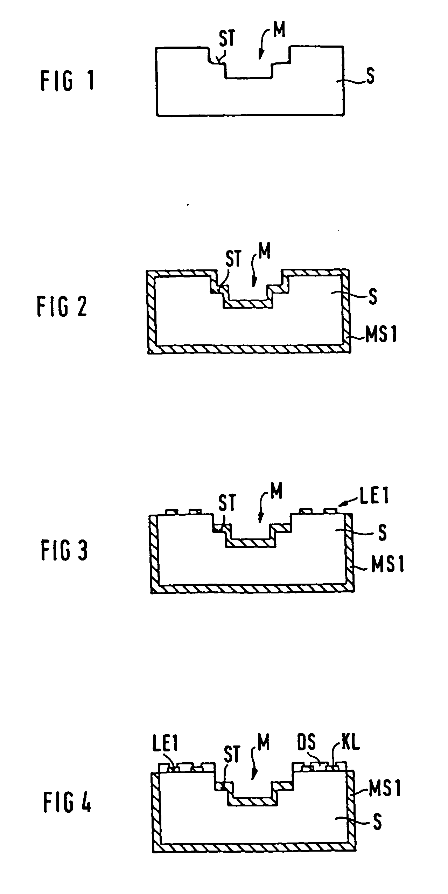

Gemäß Figur 1 wird von einem Substrat S ausgegangen, das mit einer Mulde M versehen ist, wobei diese Mulde M etwa in halber Höhe mit einer Stufe ST versehen ist. Die Herstellung des Substrats S einschließlich Mulde M und Stufe ST erfolgt durch Spritzgießen, wobei als Substratmaterialien hochtemperaturbeständige Thermoplaste wie Polyetherimid, Polyethersulfon oder Polyamid geeignet sind.

Das in Figur 1 dargestellte Spritzgießteil wird dann zur Bildung einer in Figur 2 mit MS1 bezeichneten ersten Metallschicht nach einer entsprechenden Vorbehandlung ganzflächig chemisch verkupfert und anschließend bis zu einer Gesamtstärke vom beispielsweise 15µm durch galvanische Kupferabscheidung verstärkt. Die Vorbehandlung des Spritzgießteils erfolgt beispielsweise in einer Kaliumpermanganatlösung. Die Stärke der in Figur 2 nicht mehr separat erkennbaren stromlos abgeschiedenen Kuperschicht beträgt beispielsweise 0,5µm.

Gemäß Figur 3 wird dann die erste Metallschicht MS1 im Bereich der auf der Seite der Mulde M liegenden Oberfläche des Substrats S zur Bildung einer ersten Leiterebene LE1 strukturiert. Die Strukturierung der ersten Metallschicht MS1 erfolgt dabei durch Laserablation mit Hilfe eines in Figur 3 nicht dargestellten ablenkbaren Laserstrahls.

Nach der Herstellung der ersten Leiterebene LE1 wird auf diese ganzflächig eine photoempfindliche organische Dielektrikumsschicht aufgebracht, die in Figur 4 mit DS bezeichnet ist. Das Aufbringen der beispielsweise 50µm starken Dielektrikumsschicht DS erfolgt durch Vorhangguß, durch Siebdruck oder durch Tampondruck. Als Materialien für die Dielektrikumsschicht DS können beispielsweise photoempfindliche Epoxidharze oder Polyamide verwendet werden. Ein geeignetes negativ wirkendes photoempfindliches Epoxidharz kann beispielsweise unter dem Handelsnamen Probimer 52 bei der Ciba Geigy AG, Basel (CH), bezogen werden. Die Dielektrikumsschicht DS wird zur Bildung von Kontaktlöchern KL strukturiert, wobei diese Strukturierung in bekannter Weise durch entsprechende Belichtung mittels einer Maske und nachfolgendes Entwickeln vorgenommen wird. Wie es aus Figur 4 ersichtlich ist, reichen die Kontaktlöcher KL in der Tiefe bis zur Oberfläche der zugeordneten Leiterbahnen der ersten Leiterebene LE1.

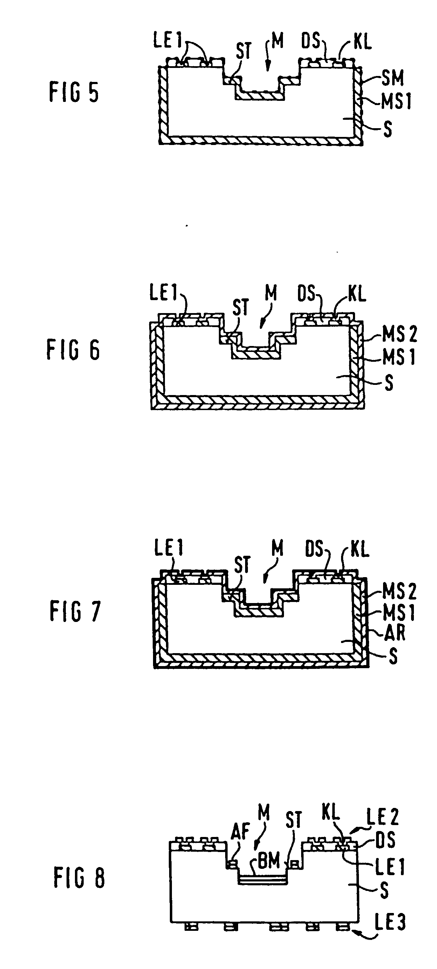

Nach dem Aufbringen und der Sturkturierung der Dielektrikumsschicht DS wird das gesamte in Figur 4 dargestellte Gebilde nach einer Vorbehandlung durch ganzflächige stromlose Kupferabscheidung mit einer beispielsweise 0,5µm starken Metallschicht überzogen. Diese stromlos abgeschiedene Metallschicht ist in Figur 5 durch eine Linie SM angedeutet.

Die stromlose abgeschiedene Metallschicht SM wird anschließend durch die ganzflächige galvanische Abscheidung von Kupfer bis zu einer Stärke von beispielsweise 15 µm verstärkt. Die resultierende zweite Metallschicht ist in Figur 6 mit MS2 bezeichnet, wobei hier die aus Figur 5 ersichtliche stromlos abgeschiedene Metallschicht SM nicht mehr als separate Schicht zu erkennen ist. Aus Figur 6 ist auch ersichtlich, daß die zweite Metallschicht MS2 im Bereich der Kontaktlöcher KL elektrisch leitend mit der darunterliegenden Leiterbahn oder Fläche der ersten Leiterebene LE1 verbunden ist.

Gemäß Figur 7 wird anschließend auf die zweite Metallschicht MS2 ganzflächig eine Ätzresistschicht AR aufgebracht. Diese Ätzresistschicht AR wird im dargestellten Ausführungsbeispiel durch die stromlose Abscheidung von Zinn hergestellt und nachfolgend mittels Laserablation strukturiert. Photoempfindliche organische Materialien, die neben den üblichen Techniken auch durch Elektrotauchlackierung aufgebracht werden können, sind als Ätzresistschicht ebenfalls geeignet. In diesem Fall wird die Strukturierung dann durch Belichtung mittels Masken und anschließendes Entwickeln vorgenommen.

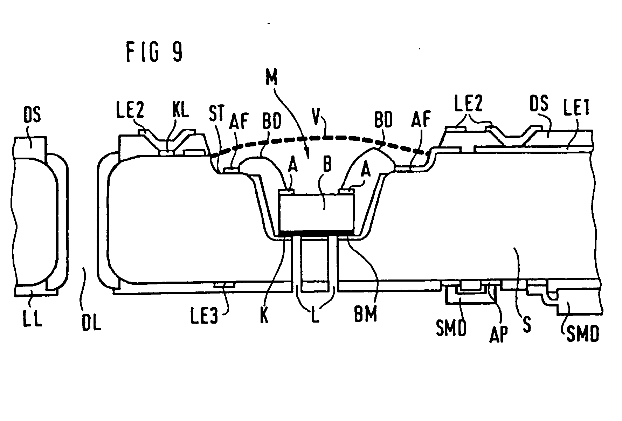

Bei der aus Figur 7 nicht ersichtlichen Strukturierung der Ätzresistschicht AR werden diejenigen Bereiche entfernt, die nicht dem gewünschten Leiterbild oder anderen erwünschten Metallflächen auf dem Substrat S entsprechen. Danach werden die nicht geschützten Bereiche der ersten Metallschicht MS1 und der zweiten Metallschicht MS2 durch Ätzen bis zur Oberfläche des Substrats S abgetragen. Figur 8 zeigt das entsprechende Gebilde nach dem Ätzen und dem Strippen der verbliebenen Ätzresistschicht AR. Auf der Oberfläche, die auf der Seite der Mulde M liegt, ist durch die Strukturierung der zweiten Metallschicht MS2 eine zweite Leiterebene LE2 entstanden, die im Bereich der Kontaktlöcher KL Durchkontaktierungen zur ersten Leiterebene LE1 aufweist. Auf der Stufe ST der Mulde M sind durch die Strukturierung der aus erster Metallschicht MS1 und zweiter Metallschicht MS2 bestehenden Gesamtschicht Anschlußflächen AF entstanden, deren Aufgabe im Zusammenhang mit Figur 9 noch zu erläutern ist. Auch im Bodenbereich der Mulde M ist eine durch die erste Metallschicht MS1 und die zweite Metallschciht MS2 gebildete Bodenmetallisierung BM verblieben. Auf der der Mulde M gegenüberliegenden Oberfläche des Substrats S ist durch die Strukturierung der aus erster Metallschicht MS1 und zweiter Metallschicht MS2 bestehenden Gesamtschicht eine weitere Leiterebene LE3 entstanden.

Bei der weiteren Schilderung des Verfahrensablaufs bei der Herstellung einer dreilagigen Verdrahtung wird auf Figur 9 verwiesen, welche einen Querschnitt durch einen Teil einer fertigen und mit Bauelementen bestückten Verdrahtung zeigt. In die Mulde M wird ein ungehäustes elektronisches Bauelement B eingesetzt und mit seiner Unterseite mit Hilfe eines elektrisch leitenden Klebers K auf der Bodenmetallisierung BM befestigt. Danach werden die Anschlüsse A des Bauelements B über feine Bonddrähte BD mit den zugeordneten Anschlußflächen AF auf der Stufe ST elektrisch leitend verbunden. Im Anschluß an die Herstellung dieser Bondverbindungen wird die Mulde M beispielsweise mit Epoxidharz ausgegossen, welches nach seiner Aushärtung eine Verkapselung V bildet, deren Kontur in Figur 9 durch eine gestrichelte Linie aufgezeigt ist. Es ist ersichtlich, daß auch die Anschlußfläche AF und die Bonddrähte BD in die Verkapselung V einbezogen sind, und somit ein optimaler Schutz aller empfindlichen Teile gewährleistet ist.

Aus Figur 9 ist auch ersichtlich, daß die weitere Leiterebene LE3 mit einem Lötstopplack LL geschützt wird, welcher so strukturiert wird, daß nur die als Anschlußpads AP dienenden Bereiche der weiteren Leiterebene LE3 freibleiben. Diese Anschlußpads AP werden dann durch die bekannte Oberflächenmontage mit SMD-Bauelementen bestückt, die in Figur 9 mit SMD bezeichnet sind.

Aus Figur 9 ist ferner ersichtlich, daß das Substrat S Durchkontaktierungslöcher DL aufweisen kann, deren Innenwandungen bei der Bildung der Metallschichten MS1 und MS2 (vergleiche Figuren 2 und 6) metallisiert werden. Dadurch können Durchkontaktierungen zwischen der ersten Leiterebene LE1 und der weiteren Leiterebene LE3 hergestellt werden.

Schließlich ist aus Figur 9 auch noch ersichtlich, daß das Substrat S im Bereich einer Mulde M auch mit Löchern L versehen sein kann, welche die Abfuhr der vom Bauelement B erzeugten Wärme begünstigen. Die Löcher L werden ebenso wie die Durchkontaktierungslöcher DL bereits beim Spritzgießen des Substrats S erzeugt. Die Innenwandungen der Löcher L sind ebenfalls mit Metall überzogen, wobei diese Metallisierung in Figur 9 jedoch nicht näher dargestellt ist.

Neben dem vorstehend anhand der Zeichnung beschriebenen Ausführungsbeispiel kann die Erfindung auch durch zahlreiche Abwandlungen realisiert werden, ohne den Erfindungsgedanken zu verlassen. Insbesondere können sowohl auf der Oberseite, als auch auf der Unterseite nach dem Aufbringen entsprechender Dielektrikumsschichten weitere Leiterebenen gebildet werden.

## Patentansprüche

1. Verfahren zur Herstellung einer zwei- oder mehrlagigen Verdrahtung mit folgenden Schritten:
- Herstellung eines mit mindestens einer Mulde (M) versehenen Substrats (S) aus einem elektrisch isolierenden Kunststoff durch Spritzgießen;
- Aufbringen einer ersten Metallschicht (MS1) auf das Substrat (S) und Strukturierung der ersten Metallschicht (MS1) zur Bildung einer ersten Leiterebene (LE1);
- Aufbringen einer Dielektrikumsschicht (DS) auf die erste Leiterebene (LE1) und Strukturierung der Dielektrikumsschicht (DS) zur Bildung von Kontaktlöchern (KL);
- Aufbringen einer zweiten Metallschicht (MS2) auf die Dielektrikumsschicht (DS) und Strukturierung der zweiten Metallschicht (MS2) zur Bildung einer zweiten Leiterebene (LE2), die im Bereich der Kontaktlöcher (KL) mit der ersten Leiterebene (LE1) elektrisch leitend verbunden ist;
- Anordnung eines elektronischen Bauelements (B) in der Mulde (M) und Herstellung elektrisch leitender Verbindungen zwischen den Anschlüssen (A) des Bauelements (B) und zugeordneten Anschlußflächen (AF) auf dem Substrat (S);
- Herstellung einer Verkapselung (V) für das Bauelement (B) durch Füllen der Mulde (M) mit Kunststoff.

2. Verfahren nach Anspruch 1,
**gekennzeichnet durch**
die Herstellung eines mit mindestens einem Durchkontaktierungsloch (DL) versehenen Substrat (S).

3. Verfahren nach Anspruch 1 oder 2,
**gekennzeichnet durch**
die Herstellung eines Substrats (S), das im Bereich der Mulde (M) mit mindestens einem Loch (L) zur Abfuhr der vom Bauelement (B) erzeugten Wärme versehen ist.

4. Verfahren nach einem der vorhergehenden Ansprüche,
**gekennzeichnet durch**
die Herstellung eines Substrats (S), dessen Mulde (M) eine Stufe (ST) aufweist und durch die Anordnung der Anschlußflächen (AF) auf der Stufe (ST).

5. Verfahren nach einem der vorhergehenden Ansprüche,
**dadurch gekennzeichnet,**
daß die erste Metallschicht (MS1) ganzflächig auf das Substrat (S) aufgebracht wird.

6. Verfahren nach einem der vorhergehenden Ansprüche,
**dadurch gekennzeichnet,**
daß die erste Metallschicht (MS1) durch stromlose und galvanische Abscheidung von Kupfer auf das Substrat (S) aufgebracht wird.

7. Verfahren nach einem der vorhergehenden Ansprüche,
**dadurch gekennzeichnet,**
daß die erste Metallschicht (MS1) zur Herstellung der ersten Leiterebene (LE1) durch Laserablation strukturiert wird.

8. Verfahren nach einem der vorhergehenden Ansprüche,
**gekennzeichnet durch**
die Verwendung einer Dielektrikumsschicht (DS) aus einem photoempfindlichem organischen Material und durch die photolithographische Strukturierung der Dielektrikumsschicht (DS).

9. Verfahren nach einem der vorhergehenden Ansprüche,
**dadurch gekennzeichnet,**
daß die zweite Metallschicht (MS2) ganzflächig auf die Dielektrikumsschicht (DS) und die erste Metallschicht aufgebracht wird.

10. Verfahren nach einem der vorhergehenden Ansprüche,
**dadurch gekennzeichnet,**
daß die zweite Metallschicht (MS2) unter Verwendung einer strukturierten Ätzresistschicht (AR) durch Ätzen strukturiert wird.

11. Verfahren nach Anspruch 10,
**gekennzeichnet durch**
die Verwendung einer Ätzresistschicht (AR) aus einem photoempfindlichen organischen Material und durch die photolithographische Strukturierung der Ätzresistschicht (AR).

12. Verfahren nach einem der Ansprüche 1 bis 10,
**gekennzeichnet durch**
die Verwendung einer Ätzresistschicht (AR) aus Zinn und durch die Strukturierung der Ätzresistschicht (AR) mittels Laserablation.

13. Verfahren nach einem der vorhergehenden Ansprüche,
**dadurch gekennzeichnet,**
daß das Bauelement (B) mit Hilfe eines Klebers (K) in der Mulde (M) befestigt wird.

14. Verfahren nach Anspruch 13,
**gekennzeichnet durch**
die Verwendung eines elektrisch leitenden Klebers (K).

15. Verfahren nach einem der vorhergehenden Ansprüche,
**dadurch gekennzeichnet,**
daß die Anschlüsse (A) des Bauelements (B) durch Bonddrähte (BD) mit den zugeordneten Anschlußflächen (AF) auf dem Substrat (S) elektrisch leitend verbunden werden.

16. Verfahren nach einem der vorhergehenden Ansprüche,
**dadurch gekennzeichnet,**
daß zur Herstellung der Verkapselung (V) die Mulde (M) mit einem härtbaren Kunstharz ausgegossen wird.

17. Verfahren nach einem der vorhergehenden Ansprüche,
**dadurch gekennzeichnet,**
daß auf der der Mulse (M), der ersten Leiterebene (LE1) und der zweiten Leiterebene (LE2) gegenüberliegenden Seite des Substrats (S) mindestens eine weitere Leiterebene (LE3) gebildet wird.

18. Verfahren nach Anspruch 17,
**dadurch gekennzeichnet,**
daß die weitere Leiterebene (LE3) durch Strukturierung der ersten Metallschicht (MS1) und der zweiten Metallschicht (MS2) gebildet wird.

19. Verfahren nach Anspruch 17 oder 18,
**dadurch gekennzeichnet,**
daß die weitere Leiterebene (LE3) über mindestens ein Durchkontaktierungsloch (DL) mit der ersten Leiteebene (LE1) elektrisch leitend verbunden wird.

20. Verfahren nach einem der Ansprüche 17 bis 19,
**dadurch gekennzeichnet,**
daß auf die weitere Leiterebene (LE3) unter Freilassung von Anschlußpads (AP) ein Lötstopplack (LL) aufgebracht wird.

21. Verfahren nach einem der Ansprüche 17 bis 20,
**dadurch gekennzeichnet,**
daß die weitere Leiterebene (LE3) mit SMD-Bauelementen (SMD) bestückt wird.

22. Zwei- oder mehrlagige Verdrahtung mit
- einem mit mindesten einer Mulde (M) versehenen, spritzgegossenen Substrat (S) aus einem elektrisch isolierenden Kunststoff;
- einer ersten Leiterebene (LE1) auf einer Seite des Substrats (S);
- einer auf die erste Leiterebene (LE1) aufgebrachten und mit Kontaktlächern (KL) versehenen Dielektrikumsschicht (DS);
- einer auf die Dielektrikumsschicht (DS) aufgebrachten zweiten Leiterebene (LE2), die im Bereich der Kontaktlöcher (KL) mit der ersten Leiterebene elektrisch leitend verbunden ist;
- einem in der Mulde (M) angeordneten elektronischen Bauelement (B), dessen Anschlüsse (A) mit zugeordneten Anschlußflächen (AF) auf dem Substrat (S) elektrisch leitend verbunden sind und mit
- einer durch Füllen der Mulde (M) mit Kunststoff gebildeten Verkapselung des Bauelements (B).

23. Zwei- oder mehrlagige Verdrahtung nach Anspruch 22,
**dadurch gekennzeichnet,**
daß die Anschlußflächen (AF) auf einer Stufe (ST) der Mulde (M) angeordnet sind.

24. Zwei- oder mehrlagige Verdrahtung nach Anspruch 22 oder 23,
**dadurch gekennzeichnet,**
daß auf die der Mulde (M), der ersten Leiterebene (LE1) und der zweiten Leiterebene (LE2) gegenüberliegende Seite des Substrats (S) mindestens eine weitere Leiterebene (LE3) aufgebracht ist.

25. Zwei- oder mehrlagige Verdrahtung nach Anspruch 24,
**dadurch gekennzeichnet,**
daß die weitere Leiterebene (LE3) über mindestens ein Durchkontaktierungsloch (DL) mit der ersten Leiterebene (LE1) elektrisch leitend verbunden ist.

## Claims

1. Method of producing a two-layer or multilayer wiring structure having the following steps:
- producing a substrate (S), provided with at least one well (M), from an electrically insulating plastic by injection moulding;
- applying a first metal layer (MS1) to the substrate (S) and structuring the first metal layer (MS1) for forming a first conductor level (LE1);
- applying a dielectric layer (DS) to the first conductor level (LE1) and structuring the dielectric layer (DS) for forming contact holes (KL);
- applying a second metal layer (MS2) to the dielectric layer (DS) and structuring the second metal layer (MS2) for forming a second conductor level (LE2), which in the region of the contact holes (KL) is connected in an electrically conducting manner to the first conductor level (LE1);
- arranging an electronic component (B) in the well (M) and establishing electrically conducting connections between the terminals (A) of the component (B) and assigned terminal areas (AF) on the substrate (S);
- producing encapsulation (V) for the component (B) by filling the well (M) with plastic.

2. Method according to Claim 1, characterized by the production of a substrate (S) provided with at least one through-plated hole (DL).

3. Method according to Claim 1 or 2, characterized by the production of a substrate (S) which is provided in the region of the well (M) with at least one hole (L) for dissipating the heat generated by the component (B).

4. Method according to one of the preceding claims, characterized by the production of a substrate (S) of which the well (M) has a step (ST) and by the arrangement of the terminal areas (AF) on the step (ST).

5. Method according to one of the preceding claims, characterized in that the first metal layer (MS1) is applied to the substrate (S) over the full surface area.

6. Method according to one of the preceding claims, characterized in that the first metal layer (MS1) is applied to the substrate (S) by non-electrical and electrolytic deposition of copper.

7. Method according to one of the preceding claims, characterized in that the first metal layer (MS1), for producing the first conductor level (LE1), is structured by laser ablation.

8. Method according to one of the preceding claims, characterized by the use of a dielectric layer (DS) of a photosensitive organic material and by the photolithographic structuring of the dielectric layer (DS).

9. Method according to one of the preceding claims, characterized in that the second metal layer (MS2) is applied to the dielectric layer (DS) and the first metal layer over the full surface area.

10. Method according to one of the preceding claims, characterized in that the second metal layer (MS2) is structured by etching, using a structured etching resist layer (AR).

11. Method according to Claim 10, characterized by the use of an etching resist layer (AR) of a photosensitive organic material and by the photolithographic structuring of the etching resist layer (AR).

12. Method according to one of Claims 1 to 10, characterized by the use of an etching resist layer (AR) of tin and by the structuring of the etching resist layer (AR) by means of laser ablation.

13. Method according to one of the preceding claims, characterized in that the component (B) is secured in the well (M) with the aid of an adhesive (K).

14. Method according to Claim 13, characterized by the use of an electrically conducting adhesive (K).

15. Method according to one of the preceding claims, characterized in that the terminals (A) of the component (B) are connected in an electrically conducting manner by bonding wires (BD) to the assigned terminal areas (AF) on the substrate (S).

16. Method according to one of the preceding claims, characterized in that, for producing the encapsulation (V), the well (M) is filled with a curable synthetic resin.

17. Method according to one of the preceding claims, characterized in that at last one further conductor level (LE3), is formed on the side of the substrate (S) opposite the well (M), the first conductor level (LE1) and the second conductor level (LE2).

18. Method according to Claim 17, characterized in that the further conductor level (LE3) is formed by structuring the first metal layer (MS1) and the second metal layer (MS2).

19. Method according to Claim 17 or 18, characterized in that the further conductor level (LE3) is connected in an electrically conducting manner to the first conductor level (LE1) via at least one through-plated hole (DL).

20. Method according to one of Claims 17 to 19, characterized in that a solder resist (LL) is applied to the further conductor level (LE3), leaving terminal pads (AP) exposed.

21. Method according to one of Claims 17 to 20, characterized in that the further conductor level (LE3) is populated with surface-mounted devices (SMDs).

22. Two-layer or multilayer wiring structure having
- an injection-moulded substrate (S) of an electrically insulating plastic, provided with at least one well (M);
- a first conductor level (LE1) on one side of the substrate (S);
- a dielectric layer (DS) applied to the first conductor level (LE1) and provided with contact holes (KL);
- a second conductor level (LE2), which is applied to the dielectric layer (DS) and, in the region of the contact holes (KL), is connected in an electrically conducting manner to the first conductor level;
- an electronic component (B) which is arranged in the well (M) and the terminals (A) of which are connected in an electrically conducting manner to assigned terminal areas (AF) on the substrate (S), and having
- encapsulation of the component (B), formed by filling the well (M) with plastic.

23. Two-layer or multilayer wiring structure according to Claim 22, characterized in that the terminal areas (AF) are arranged on a step (ST) of the well (M).

24. Two-layer or multilayer wiring structure according to Claim 22 or 23, characterized in that at least one further conductor level (LE3) is applied to the side of the substrate (S) opposite the well (M), the first conductor level (LE1) and the second conductor level (LE2).

25. Two-layer or multilayer wiring structure according to Claim 24, characterized in that the further conductor level (LE3) is connected in an electrically conducting manner to the first conductor level (LE1) via at least one through-plated hole (DL).

## Revendications

1. Procédé de fabrication d'un câblage à deux ou plusieurs couches, comprenant les phases suivantes :
- fabrication d'un substrat (S) pourvu d'au moins un creux (M), à partir d'une matière plastique électriquement isolante par moulage par injection ;
- application sur le substrat (S) d'une première couche métallique (MS1) et structuration de la première couche métallique (MS1) pour former un premier niveau de conducteurs (LE1) ;
- application sur le premier niveau de conducteurs (LE1) d'une couche diélectrique (DS) et structuration de la couche diélectrique (DS) pour former des trous de contact (KL) ;
- application sur la couche diélectrique (DS) d'une deuxième couche métallique (MS2) et structuration de la deuxième couche métallique (MS2) pour former un deuxième niveau de conducteurs (LE2) qui est relié au premier niveau de conducteurs (LE1) dans la partie des trous de contact (KL), de manière à établir des connexions électroconductrices ;
- implantation d'un composant électronique (B) dans le creux (M) et réalisation de connexions électroconductrices entre les bornes (A) du composant (B) et des surfaces de connexion (AF) associées sur le substrat (S);
- réalisation d'un blindage (V) pour le composant (B) en remplissant le creux (M) de matière plastique.

2. Procédé selon la revendication 1, caractérisé par la fabrication d'un substrat (S) pourvu d'au moins un trou à connexion traversante (DL).

3. Procédé selon la revendication 1 ou 2, caractérisé par la fabrication d'un substrat (S) qui est pourvu au niveau du creux (M) d'au moins un trou (L) pour dissiper la chaleur produite par le composant (B).

4. Procédé selon l'une des revendications précédentes, caractérisé par la fabrication d'un substrat (S) dont le creux (M) comporte un palier (ST), et par la disposition des surfaces de connexion (AF) sur le palier (ST).

5. Procédé selon l'une des revendications précédentes, caractérisé en ce que la première couche métallique (MS1) est appliquée sur toute la surface du substrat (S).

6. Procédé selon l'une des revendications précédentes, caractérisé en ce que la première couche métallique (MS1) est appliquée sur le substrat (S) par dépôt sans courant et galvanique de cuivre.

7. Procédé selon l'une des revendications précédentes, caractérisé en ce que la première couche métallique (MS1) est structurée par ablation au laser pour réaliser le premier niveau de conducteurs (LE1).

8. Procédé selon l'une des revendications précédentes, caractérisé par l'utilisation d'une couche diélectrique (DS) en matériau organique photosensible et par la structuration photolithographique de la couche diélectrique (DS).

9. Procédé selon l'une des revendications précédentes, caractérisé en ce que la deuxième couche métallique (MS2) est appliquée sur toute la surface de la couche diélectrique (DS) et de la première couche métallique.

10. Procédé selon l'une des revendications précédentes, caractérisé en ce que la deuxième couche métallique (MS2) est structurée par gravure par application d'une couche (AR) résistante à la gravure structurée.

11. Procédé selon la revendication 10, caractérisé par l'utilisation d'une couche (AR) résistante à la gravure en matériau organique photosensible et par la structuration photolithographique de la couche (AR) résistante à la gravure.

12. Procédé selon l'une des revendications 1 à 10, caractérisé par l'utilisation d'une couche (AR) résistante à la gravure en étain et par la structuration de la couche (AR) résistante à la gravure par ablation au laser.

13. Procédé selon l'une des revendications précédentes, caractérisé en ce que le composant (B) est fixé dans le creux (M) à l'aide d'une colle (K).

14. Procédé selon la revendication 13, caractérisé par l'utilisation d'une colle (K) électroconductrice.

15. Procédé selon l'une des revendications précédentes, caractérisé en ce que les bornes (A) du composant (B) sont reliées aux surfaces de connexion (AF) associées sur le substrat (S) au moyen de fils de connexion (BD), de manière à établir des connexions électroconductrices.

16. Procédé selon l'une des revendications précédentes, caractérisé en ce qu'une résine synthétique durcissable est coulée dans le creux (M) pour réaliser le blindage (V).

17. Procédé selon l'une des revendications précédentes, caractérisé en ce qu'au moins un niveau de conducteurs (LE3) supplémentaire est formé sur la face du substrat (S) opposée au creux (M), au premier niveau de conducteurs (LE1) et au deuxième niveau de conducteurs (LE2).

18. Procédé selon la revendication 17, caractérisé en ce que le niveau de conducteurs (LE3) supplémentaire est formé par structuration de la première couche métallique (MS1) et de la deuxième couche métallique (MS2).

19. Procédé selon la revendication 17 ou 18, caractérisé en ce que le niveau de conducteurs (LE3) supplémentaire est relié au premier niveau de conducteurs (LE1) par l'intermédiaire d'au moins un trou à connexion traversante (DL), de manière à établir une connexion électroconductrice.

20. Procédé selon l'une des revendications 17 à 19, caractérisé en ce qu'un vernis résistant à la soudure (LL) est appliqué sur le niveau de conducteurs (LE3) supplémentaire en ménageant des plaques à bornes (AP).

21. Procédé selon l'une des revendications 17 à 20, caractérisé en ce que le niveau de conducteurs (LE3) supplémentaire est équipé de composants SMD (SMD).

22. Câblage à deux ou plusieurs couches, comportant
- un substrat (S) moulé par injection en matière plastique électriquement isolante, pourvu d'au moins un creux (M) ;
- un premier niveau de conducteurs (LE1) sur une face du substrat (S);
- une couche diélectrique (DS) déposée sur le premier niveau de conducteurs (LE1) et pourvue de trous de contact (KL) ;
- un deuxième niveau de conducteurs (LE2) déposé sur la couche diélectrique (DS), qui est relié au premier niveau de conducteurs dans la partie des trous de contact (KL), de manière à établir des connexions électroconductrices ;
- un composant électronique (B) disposé dans le creux (M), dont les bornes (A) sont reliées à des surfaces de connexion (AF) associées sur le substrat (S), de manière à établir des connexions électroconductrices, et
- un blindage du composant (B), obtenu en remplissant le creux (M) de matière plastique.

23. Câblage à deux ou plusieurs couches selon la revendication 22, caractérisé en ce que les surfaces de connexion (AF) sont disposées sur un palier (ST) du creux (M).

24. Câblage à deux ou plusieurs couches selon la revendication 22 ou 23, caractérisé en ce qu'au moins un niveau de conducteurs (LE3) supplémentaire est déposé sur la face du substrat (S) opposée au creux (M), au premier niveau de conducteurs (LE1) et au deuxième niveau de conducteurs (LE2).

25. Câblage à deux ou plusieurs couches selon la revendication 24, caractérisé en ce que le niveau de conducteurs (LE3) supplémentaire est relié au premier niveau de conducteurs (LE1) par l'intermédiaire d'au moins un trou à connexion traversante (DL), de manière à établir une connexion électroconductrice.
